# EUROPEAN PATENT APPLICATION

(11) **EP 4 389 800 A1**
(43) Date of publication of application: **26.06.2024**
(21) Application number: 22858444.7
(22) Date of filing: 15.08.2022
(51) Int. Cl.: C08G 73/22

(54) **FLUORINE-CONTAINING POLYAMIDE COMPOUND AND FLUORINE-CONTAINING POLYBENZOXAZOLE**

(30) Priority: 17.08.2021 JP 2021133005
(71) Applicant: Daikin Industries, Ltd., Osaka-shi, Osaka 530-0001 (JP); NATIONAL UNIVERSITY CORPORATION, IWATE UNIVERSITY, Morioka-shi, Iwate 020-8550 (JP)
(72) Inventor: OISHI, Yoshiyuki, Morioka-shi, Iwate 020-8550 (JP); NOGUCHI, Tsuyoshi, Osaka-shi, Osaka 530-0001 (JP)
(74) Representative: Hoffmann Eitle
(86) International application number: PCT/JP2022/030862
(87) International publication number: WO 2023/022123

(57) **Abstract**

Provided is a fluorine-containing polyamide compound having a specific repeating unit and a fluorine-containing polybenzoxazole having a specific repeating unit.

## Description

### TECHNICAL FIELD

The present disclosure relates to a fluorine-containing polyamide compound and a fluorine-containing polybenzoxazole.

### BACKGROUND ART

Like polyimide resins, polybenzoxazole resins have excellent heat resistance and mechanical properties, and are used as an interlayer insulating film or a protective film for semiconductors, an interlayer insulating film for multilayer circuits, a cover coating for flexible wiring boards, solder resists, and the like. In order to apply to such electrical and electronic materials, methods for producing polyhydroxyamide, which is a highly pure polybenzoxazole precursor that does not contain ionic impurities, have been proposed (Patent Document 1 and Patent Document 2).

Patent Document 2 describes a polybenzoxazole precursor resin obtained by a polymerization reaction between a dicarboxylic acid triazine active ester represented by the following Formula (A), 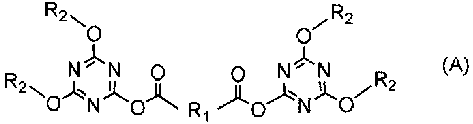 (wherein R₁ represents a divalent aromatic residue containing one or more elements selected from O, N, S, F, and Si in its structure, or a divalent organic group having 1 to 12 carbon atoms, and R₂ represents an alkyl group having 1 to 4 carbon atoms or an aromatic residue having 6 to 8 carbon atoms) and a bisaminophenol compound, which has a weight average molecular weight in the range of 10,000 to 1,000,000 and an ionic impurity content of 10 ppm or less.

In addition, in order to apply to printed circuit boards and the like, a fluorine-containing polybenzoxazole having an introduced fluorine atom with low polarizability has been reported (Patent Document 3, Patent Document 4, and Patent Document 5).

However, there is a need for a polybenzoxazole resin that has a low dielectric constant, low dielectric tangent, and good moldability that can be used in high-frequency printed circuit boards.

### RELATED ART

### PATENT DOCUMENTS

Patent Document 1: Japanese Patent Laid-Open No. 9-183846
Patent Document 2: Japanese Patent Laid-Open No. 2011-256219
Patent Document 3: Japanese Patent Laid-Open No. 2000-212281
Patent Document 4: Japanese Patent Laid-Open No. 2000-219742
Patent Document 5: Japanese Patent Laid-Open No. 2006-45321

### SUMMARY OF THE INVENTION

### PROBLEM TO BE SOLVED BY THE INVENTION

It is an object of the present disclosure to provide a highly soluble fluorine-containing polyamide compound from which a fluorine-containing polybenzoxazole having a dielectric constant and a dielectric tangent that are low enough for use in a high-frequency printed circuit board can be obtained.

Further, it is an object of the present disclosure to provide a fluorine-containing polybenzoxazole having a dielectric constant and a dielectric tangent that are low enough for use in a high-frequency printed circuit board.

### MEANS FOR SOLVING THE PROBLEM

According to the present disclosure, there is provided a fluorine-containing polyamide compound including a repeating unit represented by Formula (1).

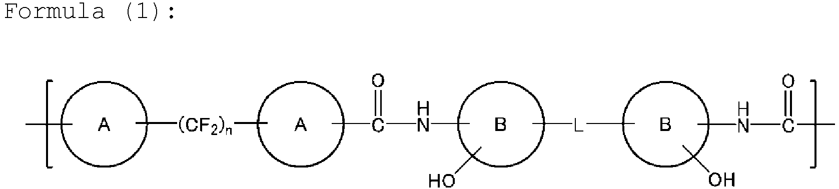

(In Formula (1), n represents an integer of 1 to 8, L represents a linking group, and each ring A and each ring B independently represents a hydrocarbon ring.)

In Formula (1), the ring A is preferably a cyclohexane ring, a benzene ring, a naphthalene ring, a biphenyl ring, an anthracene ring, or a terphenyl ring.

In Formula (1), the ring B is preferably a cyclohexane ring, a benzene ring, a naphthalene ring, a biphenyl ring, an anthracene ring, or a terphenyl ring.

In Formula (1), the linking group is preferably single bond, -SO₂-, -O-, -CO-, a divalent non-fluorinated organic group, or a divalent fluorinated organic group.

The repeating unit represented by Formula (1) is preferably a repeating unit represented by Formula (1-1).

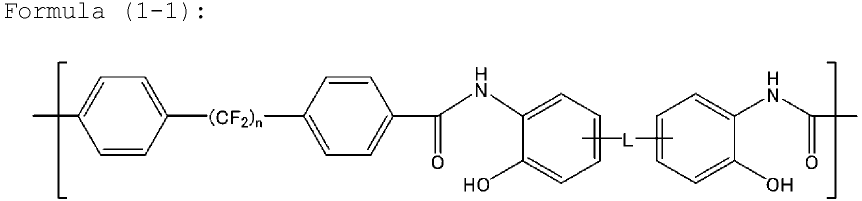

(In Formula (1-1), n and L are as described above.)

The average degree of polymerization of the repeating unit represented by Formula (1) is preferably 2 to 100.

Further, according to the present disclosure, there is provided a fluorine-containing polybenzoxazole including a repeating unit represented by Formula (2).

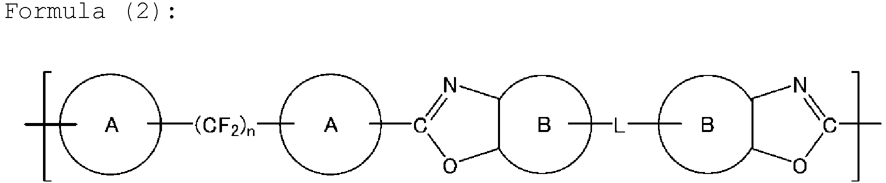

(In Formula (2), n represents an integer of 1 to 8, L represents a linking group, and each ring A and each ring B independently represents a hydrocarbon ring.)

In Formula (2), the ring A is preferably a cyclohexane ring, a benzene ring, a naphthalene ring, a biphenyl ring, an anthracene ring, or a terphenyl ring.

In Formula (2), the ring B is preferably a cyclohexane ring, a benzene ring, a naphthalene ring, a biphenyl ring, an anthracene ring, or a terphenyl ring.

In Formula (2), the linking group is preferably single bond, -SO₂-, -O-, -CO-, a divalent non-fluorinated organic group, or a divalent fluorinated organic group.

The repeating unit represented by Formula (2) is preferably a repeating unit represented by Formula (2-1).

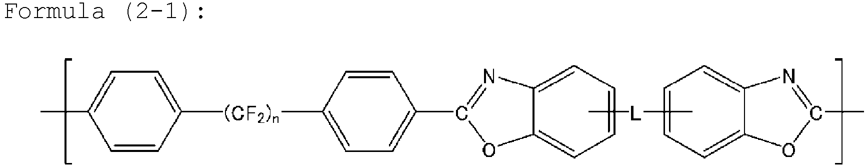

(In Formula (2-1), n and L are as described above.)

The average degree of polymerization of the repeating unit represented by Formula (2) is preferably 2 to 100.

Further, according to the present disclosure, there is provided a low dielectric material containing the above-mentioned fluorine-containing polyamide compound or the above-mentioned fluorine-containing polybenzoxazole.

In addition, according to the present disclosure, there is provided an insulation material of a printed circuit board containing the above-mentioned fluorine-containing polyamide compound or the above-mentioned fluorine-containing polybenzoxazole.

### EFFECTS OF INVENTION

According to the present disclosure, there can be provided a highly soluble fluorine-containing polyamide compound from which a fluorine-containing polybenzoxazole having a low dielectric constant and a low dielectric tangent can be obtained.

Further, according to the present disclosure, there can be provided a fluorine-containing polybenzoxazole having a low dielectric constant and a low dielectric tangent.

### DESCRIPTION OF EMBODIMENTS

Hereinafter, specific embodiments of the present disclosure will be described in detail, but the present disclosure is not limited to the following embodiments.

### <Fluorine-containing polyamide compound>

The fluorine-containing polyamide compound of the present disclosure has a repeating unit represented by Formula (1).

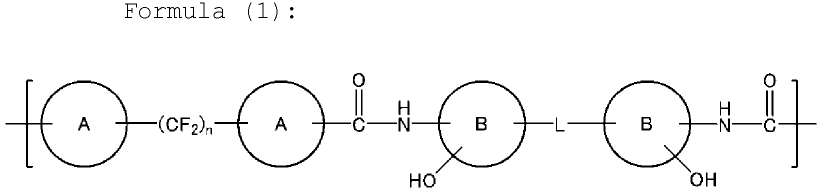

(In Formula (1), n represents an integer of 1 to 8, L represents a linking group, and each ring A and each ring B independently represents a hydrocarbon ring.)

n represents an integer of 1 to 8. n is preferably an integer of 4 to 8, and more preferably 4, 6, or 8.

L represents a linking group. The linking group is preferably single bond, -SO₂-, -O-, -CO-, a divalent non-fluorinated organic group, or a divalent fluorinated organic group, more preferably single bond, -O-, a divalent non-fluorinated organic group, or a divalent fluorinated organic group, further preferably a divalent non-fluorinated organic group or a divalent fluorinated organic group, and particularly preferably a divalent fluorinated organic group.

The non-fluorinated organic group is a divalent organic group that does not have fluorine atom. The non-fluorinated organic group is preferably a linear or branched chain non-fluorinated alkylene group, or a non-fluorinated arylene group.

The fluorinated organic group is a divalent organic group having one or more fluorine atoms. L is preferably a linear or branched chain fluorinated alkylene group.

The fluorinated alkylene group is preferably a perfluoroalkylene group.

From the perspective that the dielectric constant and dielectric tangent of the fluorine-containing polyamide compound can be made much lower, and the perspective that solubility can be increased much more, the number of carbons of the fluorinated alkylene group is preferably 1 to 15, and more preferably 2 or more, and more preferably 10 or less, and further preferably 6 or less.

The fluorinated alkylene group is preferably - C(CF₃)₂-.

Each ring A and each ring B independently represents a hydrocarbon ring. The hydrocarbon ring may be a monocyclic or polycyclic ring, and may be an aliphatic hydrocarbon ring or an aromatic hydrocarbon ring. The aliphatic hydrocarbon ring may be a non-aromatic saturated or unsaturated hydrocarbon ring.

The position where the carbonyl group and the difluoromethylene group adjacent to the hydrocarbon ring of the ring A are bonded to the hydrocarbon ring is not limited. The carbonyl group and the difluoromethylene group may be bonded to any of the carbon atoms constituting the hydrocarbon ring.

The number of carbons of the ring A is preferably 3 to 30, more preferably 5 or more, and further preferably 6 or more, and more preferably 20 or less, and further preferably 18 or less.

The hydrocarbon ring of the ring A optionally has a substituent. Examples of the substituent include a halogen atom such as a fluorine atom, an alkyl group such as a methyl group, an alkyl halide group such as a trifluoromethyl group, an aryl group such as a phenyl group, and the like.

Examples of the ring A include:
monocyclic saturated hydrocarbon rings, such as a cyclopropane ring, a cyclobutane ring, a cyclopentane ring, a cyclohexane ring, a cycloheptane ring, a cyclooctane ring, a cyclononane ring, a cyclodecane ring, a cycloundecane ring, and a cyclododecane ring;
a monocyclic non-aromatic unsaturated hydrocarbon rings, such as a cyclopropene ring, a cyclobutene ring, a cyclopropene ring, a cyclohexene ring, a cycloheptene ring, and a cyclooctene ring;
polycyclic non-aromatic hydrocarbon rings, such as a norbornene ring, a norbornadiene ring, a decahydronaphthalene ring, a bicycloundecane ring, and a spirobicyclopentane ring;
aromatic hydrocarbon rings, such as a benzene ring, a naphthalene ring, a phenanthrene ring, an anthracene ring, a fluorene ring, a tetracene ring, a chrysene ring, a pyrene ring, a pentacene ring, a benzopyrene ring, a triphenylene ring, a biphenyl ring, a terphenyl group, a diphenylmethane ring, a diphenyl ether ring, a diphenyl sulfone ring, and a diphenyl ketone ring;
and the like.

Among these, the ring A is preferably a benzene ring, a naphthalene ring, an anthracene ring, a biphenyl ring, or a terphenyl ring, and more preferably a benzene ring. These examples optionally have a substituent.

The position where the amino group and the linking group of L adjacent to the hydrocarbon ring of the ring B are bonded to the hydrocarbon ring is not limited. The amino group and the linking group of L may be bonded to any of the carbon atoms constituting the hydrocarbon ring.

The number of carbon atoms in the ring B is preferably 3 to 30, more preferably 5 or more, and further preferably 6 or more, and is more preferably 20 or less, and further preferably 18 or less.

The hydrocarbon ring of the ring B optionally has a substituent. Examples of the substituent include a halogen atom such as a fluorine atom, an alkyl group such as a methyl group, an alkyl halide group such as a trifluoromethyl group, an aryl group such as a phenyl group, and the like.

Examples of the ring B include:
monocyclic saturated hydrocarbon rings, such as a cyclopropane ring, a cyclobutane ring, a cyclopentane ring, a cyclohexane ring, a cycloheptane ring, a cyclooctane ring, a cyclononane ring, a cyclodecane ring, a cycloundecane ring, and a cyclododecane ring;
a monocyclic non-aromatic unsaturated hydrocarbon rings, such as a cyclopropene ring, a cyclobutene ring, a cyclopropene ring, a cyclohexene ring, a cycloheptene ring, and a cyclooctene ring;
polycyclic non-aromatic hydrocarbon rings, such as a norbornene ring, a norbornadiene ring, a decahydronaphthalene ring, a bicycloundecane ring, and a spirobicyclopentane ring;
aromatic hydrocarbon rings, such as a benzene ring, a naphthalene ring, a phenanthrene ring, an anthracene ring, a fluorene ring, a tetracene ring, a chrysene ring, a pyrene ring, a pentacene ring, a benzopyrene ring, a triphenylene ring, a biphenyl ring, a terphenyl group, a diphenylmethane ring, a diphenyl ether ring, a diphenyl sulfone ring, and a diphenyl ketone ring;
and the like.

Among these, the ring B is preferably a benzene ring, a naphthalene ring, an anthracene ring, a biphenyl ring, or a terphenyl ring, and more preferably a benzene ring. These examples optionally have a substituent.

For the repeating unit represented by Formula (1), the repeating unit represented by Formula (1-1) is preferable.

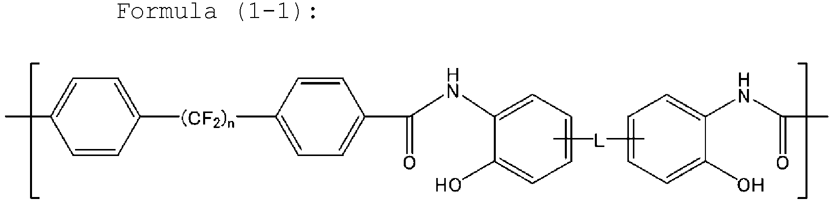

(In Formula (1-1), n and L are as described above.)

In the fluorine-containing polyamide compound of the present disclosure, the average degree of polymerization of the repeating unit represented by Formula (1) is preferably 200 or less, more preferably 150 or less, and further preferably 100 or less, and may be 2 or more, or may be 3 or more. The average degree of polymerization is determined based on a calculation from the number average molecular weight (Mn) of the fluorine-containing polyamide compound of the present disclosure.

The number average molecular weight (Mn) of the fluorine-containing polyamide compound of the present disclosure is, in terms of standard polystyrene by gel permeation chromatography (GPC), preferably 10,000 or more, and more preferably 20,000 or more, and preferably 1,000,000 or less, and more preferably 500,000 or less.

The molecular weight distribution (Mw/Mn) of the fluorine-containing polyamide compound of the present disclosure is, in terms of standard polystyrene by gel permeation chromatography (GPC), preferably 2 or more, and preferably 5 or less, and more preferably 4 or less.

The logarithmic viscosity ηᵢₙₕ of the fluorine-containing polyamide compound of the present disclosure is preferably 0.3 dL/g or more, and more preferably 0.5 dL/g or more. The logarithmic viscosity ηᵢₙₕ can be calculated by the following formula by dissolving the fluorine-containing polyamide compound in a solvent such as N-methyl-2-pyrrolidone (NMP) to prepare a solution having a solution concentration of 0.5 g/dL and measuring the viscosity of the prepared solution at 30°C. Logarithmic viscosity ηinh = ln (solution viscosity / solvent viscosity) / solution concentration

The fluorine-containing polyamide compound of the present disclosure can be suitably used as a precursor of the fluorine-containing polybenzoxazole having a repeating unit represented by Formula (2) described below.

### <Fluorine-containing polybenzoxazole>

The fluorine-containing polybenzoxazole of the present disclosure has a repeating unit represented by Formula (2).

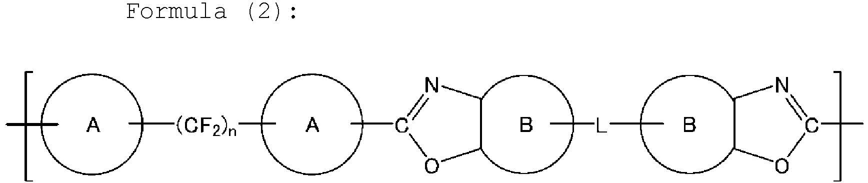

(In Formula (2), n represents an integer of 1 to 8, L represents a linking group, and each ring A and each ring B independently represents a hydrocarbon ring.)

In Formula (2), n, L, ring A, and ring B are the same as the n, L, ring A, and ring B in Formula (1).

The repeating unit represented by Formula (2) is preferably a repeating unit represented by Formula (2-1).

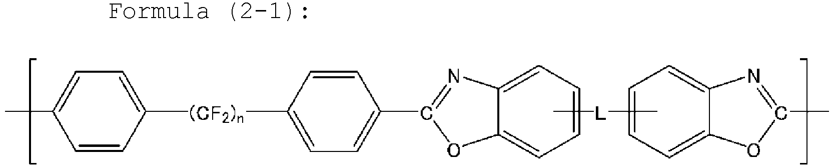

(In Formula (2-1), n and L are as described above.)

The glass transition temperature of the fluorine-containing polybenzoxazole of the present disclosure is preferably 50 to 400°C, more preferably 100 to 350°C, and further preferably 150 to 260°C. The glass transition temperature is a value measured by differential scanning calorimetry (DSC), dynamic viscoelasticity measurement (DMA), or thermomechanical analysis (TMA).

In the fluorine-containing polybenzoxazole of the present disclosure, the average degree of polymerization of the repeating unit represented by Formula (2) is preferably 200 or less, more preferably 100 or less, and may be 2 or more, or may be 3 or more. The average degree of polymerization is determined based on a calculation from the number average molecular weight (Mn) of the fluorine-containing polybenzoxazole of the present disclosure.

From the perspective that the dielectric constant and dielectric tangent of the fluorine-containing polybenzoxazole can be made much lower, the fluorine-containing polybenzoxazole is preferably a polymer having a comparatively large average degree of polymerization, for example, a polymer having an average degree of polymerization of more than 100.

The number average molecular weight (Mn) of the fluorine-containing polybenzoxazole of the present disclosure is, in terms of standard polystyrene by gel permeation chromatography, preferably 10,000 or more, and more preferably 20,000 or more, and preferably 1,000,000 or less, and more preferably 500,000 or less.

The molecular weight distribution (Mw/Mn) of the fluorine-containing polybenzoxazole of the present disclosure is, in terms of standard polystyrene by gel permeation chromatography, preferably 2 or more, and preferably 5 or less, and more preferably 4 or less.

The logarithmic viscosity ηᵢₙₕ of the fluorine-containing polybenzoxazole of the present disclosure is preferably 0.3 dL/g or more, and more preferably 0.5 dL/g or more. The logarithmic viscosity ηᵢₙₕ can be calculated by the following formula by dissolving the fluorine-containing polybenzoxazole in a solvent such as N-methyl-2-pyrrolidone (NMP) to prepare a solution having a solution concentration of 0.5 g/dL and measuring the viscosity of the prepared solution at 30°C. Logarithmic viscosity ηinh = ln (solution viscosity / solvent viscosity) / solution concentration

### <Method for producing fluorine-containing polyamide compound>

The fluorine-containing polyamide compound of the present disclosure can be suitably produced by producing a fluorinated compound (3) represented by Formula (3) by the production method described later, and then polymerizing the obtained fluorinated compound (3) with a compound (4) represented by Formula (4).

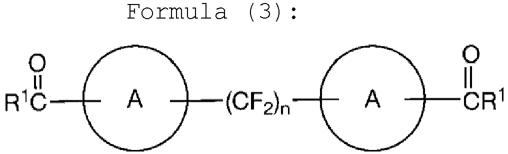

(In Formula (3), n represents an integer of 1 to 8, ring A represents a hydrocarbon ring, and each R¹ independently represents OH, an optionally-substituted linear or branched chain alkoxy group, an optionally-substituted aromatic oxy group, or a halogen atom.)

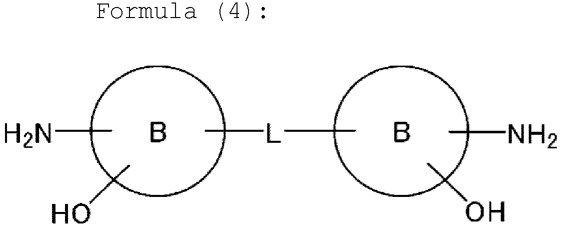

(In Formula (4), L represents a linking group and ring B represents a hydrocarbon ring.)

In Formula (3), n and the ring A are the same as n and the ring A in Formula (1).

In Formula (3), each R¹ independently represents OH, an optionally-substituted linear or branched chain alkoxy group, an optionally-substituted aromatic oxy group, or a halogen atom.

The number of carbon atoms of the alkoxy group as R¹ is preferably 1 to 12, and more preferably 1 to 6.

The optional substituent of the alkoxy group and the aromatic oxy group as R¹ is preferably an alkoxy group, an alkyl group, a fluorinated alkyl group, a halo group (halogen atom), a nitro group, a cyano group, or an ester group, and more preferably is an alkoxy group.

Examples of the aromatic oxy group as R¹ include an optionally-substituted phenoxy group, an optionally-substituted triazinyloxy group, and the like.

It is preferable that each R¹ is independently OH, an optionally-substituted phenoxy group, a methoxy group, an ethoxy group, a chlorine atom, or the following.

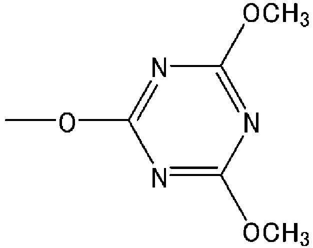

The fluorinated compound (3) is preferably a compound represented by Formula (3-1).

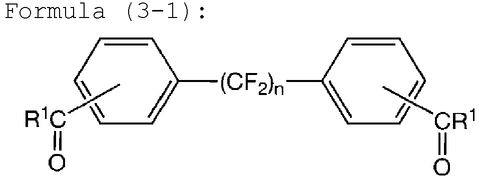

(In Formula (3-1), n and R¹ are as described above.)

The fluorinated compound (3) is more preferably a compound represented by Formula (3-1a) or Formula (3-1b).

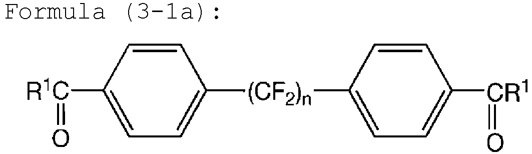

(In Formula (3-1a), n and R¹ are as described above.)

Formula (3-1b):

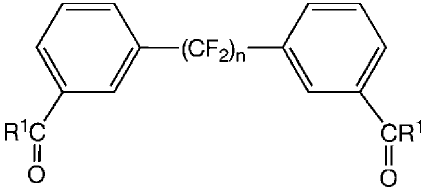

(In Formula (3-1b), n and R¹ are as described above.)

In Formula (4), L and the ring B are the same as L and the ring B in Formula (1).

The fluorinated compound (4) is preferably a compound represented by Formula (4-1).

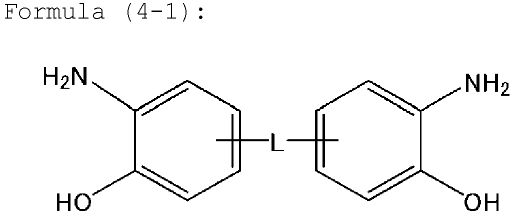

(In Formula (4-1), L is as described above.)

The polymerization of the fluorinated compound (3) and the compound (4) can be carried out in a solvent. It is desirable that the solvent does not substantially react with the fluorinated compound (3) and the compound (4), has the property of dissolving the fluorinated compound (3) and the compound (4) well, and is a good solvent for the compound obtained by polymerization of the fluorinated compound (3) and the compound (4). Such a solvent is not limited, and examples thereof include dimethyl sulfoxide (DMSO), N,N-dimethylformamide (DMF), N,N-dimethylacetamide (DMAc), N-methyl-2-pyrrolidone (NMP), 1,3-dimethylimidazolidone (DMI), tetramethylurea (TMU), N,N'-dimethylpropyleneurea (DMPU), dimethylsulfone, sulfolane, tetrahydrofuran (THF), cyclopentanone, cyclohexanone, and acetone. Of these, N-methyl-2-pyrrolidone (NMP) and 1,3-dimethylimidazolidone (DMI) are preferable. The amount of these solvents used is, based on 0.1 mol of the fluorinated compound (3) or the compound (4), usually 10 to 1,000 mL, preferably 50 to 400 mL.

The polymerization can also be carried out in the presence of additives. For example, an inorganic salt such as lithium chloride or calcium chloride may be added in order to obtain a compound having a large molecular weight. Of these, lithium chloride is preferable as the additive. The amount of the additive added is, based on the amount of the solvent, preferably 10% by mass or less, and more preferably 5% by mass or less. Further, in order to obtain a compound having a large molecular weight, a silylating agent such as trialkylsilyl chloride, N,O-bis(trimethylsilyl)acetamide (BSA), and N,O-bis(trimethylsilyl)trifluoroacetamide (BSTFA) may be added. Among these, BSA is preferable as the silylating agent. The amount of the silylating agent added is preferably not more than 4 times the molar amount of compound (4), and more preferably is 1 to 2 times that molar amount.

The polymerization can be carried out by, for example, dissolving any one of the fluorinated compound (3) and the compound (4) in the solvent, adding the other compound to the resulting solution, and then carrying out the reaction while stirring under an inert atmosphere such as nitrogen. The polymerization temperature is preferably -50 to 100°C, and more preferably -10 to 80°C. The polymerization time is preferably 0.1 to 50 hours, and more preferably 1 to 24 hours.

The average degree of polymerization of the repeating unit represented by Formula (1) can be adjusted by changing the molar ratio of the fluorinated compound (3) to the compound (4), the polymerization temperature, the polymerization time, the concentration of the polymerization solution, and the like.

Generally, a solution of the fluorine-containing polyamide compound is obtained by the production method described above. The obtained solution of the fluorine-containing polyamide compound may be used as it is for various purposes. Further, a highly pure fluorine-containing polyamide compound may be obtained by charging the obtained solution of the fluorine-containing polyamide compound into a poor solvent such as methanol or water to separate the fluorine-containing polyamide compound, and then purifying by a reprecipitation method to remove by-products, inorganic salts, and the like.

Next, a method for producing the fluorinated compound (3) represented by Formula (3) will be described. The fluorinated compound (3) in which R¹ is OH can be produced by reacting a compound (5) represented by Formula (5) with a compound (6) represented by Formula (6) to obtain a compound (7) represented by Formula (7), and then oxidizing the obtained compound (7).

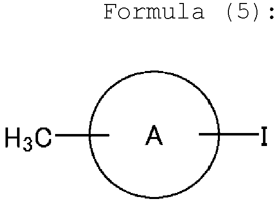

(In Formula (5), the ring A is the same as in Formula (3).)

Formula (6): I-(CF₂)ₙ-I

(In Formula (6), n is the same as in Formula (3).) Formula (7):

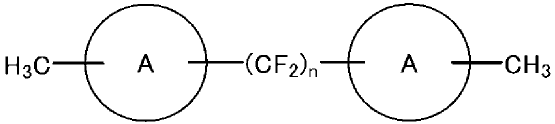

(In Formula (7), n and the ring A are the same as in Formula (3).)

The compound (5) is preferably a compound represented by Formula (5-1), and more preferably is 4-iodotoluene or 3-iodotoluene.

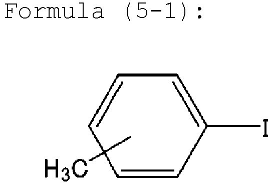

The compound (7) is preferably a compound represented by Formula (7-1).

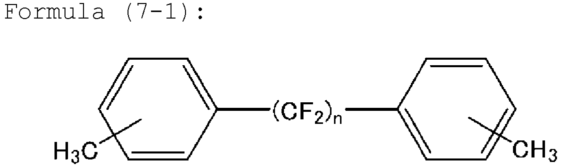

(In Formula (7-1), n is the same as in Formula (3).)

Further preferably, the compound (7) is a compound represented by Formula (7-1a) or Formula (7-1b).

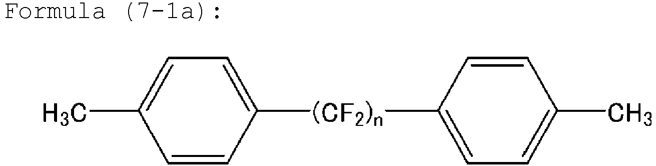

(In Formula (7-1a), n is the same as in Formula (3).)

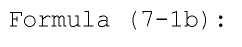

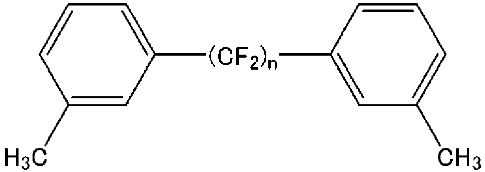

(In Formula (7-1b), n is the same as in Formula (3).)

Further, by reacting the fluorinated compound (3) in which R¹ is OH with a compound (8) represented by Formula (8), a fluorinated compound (3) having a desired group represented by R¹ (for example, an alkoxy group or an aromatic oxy group) can be produced.

Formula (8): R-OH

(In Formula (8), R is an optionally-substituted linear or branched chain alkyl group or an optionally-substituted aromatic group.)

Further, by reacting the fluorinated compound (3) in which R¹ is OH with a halogenating agent, a fluorinated compound (3) in which R¹ is a halogen atom can be produced.

Further, by reacting the fluorinated compound (3) in which R¹ is OH with a triazine chloride compound, a fluorinated compound (3) in which R¹ is a triazinyloxy group can be produced.

The reaction between the compound (5) and the compound (6) can be carried out in a solvent. It is desirable that the solvent does not substantially react with the compound (5) and the compound (6), has the property of dissolving the compound (5) and the compound (6) well, and is a good solvent for the obtained compound (7). Such a solvent is not limited, and examples thereof include dimethyl sulfoxide (DMSO), N,N-dimethylformamide (DMF), N,N-dimethylacetamide (DMAc), N-methyl-2-pyrrolidone (NMP), 1,3-dimethylimidazolidone (DMI), sulfolane, tetrahydrofuran (THF), cyclohexanone, and acetone. Of these, dimethyl sulfoxide (DMSO) is preferable. The amount of these solvents used is, based on 0.1 mol of the compound (5) and the compound (6), usually 10 to 1,000 mL, preferably 50 to 400 mL.

The reaction between the compound (5) and the compound (6) can be carried out by, for example, dissolving any one of the compound (5) and compound (6) in the solvent, adding the other compound to the resulting solution, and then carrying out the reaction while stirring under an inert atmosphere such as nitrogen. The reaction temperature is preferably 50 to 150°C, and more preferably 100 to 140°C. The reaction time is preferably 0.5 to 50 hours, and more preferably 1 to 30 hours.

The reaction between the compound (5) and the compound (6) may be carried out by adding a base such as 2,2'-bipyridyl and reacting in the presence of a catalyst such as copper or a copper compound.

The oxidation of the compound (7) can be performed using, for example, an oxidizing agent such as CrO₃ or KMnO₄. Further, the oxidation of the compound (7) is preferably carried out in the presence of an acidic compound such as sulfuric acid or acetic acid.

Examples of the halogenating agent used in the reaction between the fluorinated compound (3) in which R¹ is OH and the halogenating agent include thionyl chloride, phosphorus trichloride, phosphorus pentachloride, and the like. The reaction temperature may be, for example, 20 to 100°C. The reaction between the fluorinated compound (3) and the halogenating agent can also be carried out in a solvent. Examples of the solvent include an ether-based solvent such as diethyl ether and tetrahydrofuran.

The reaction between the fluorinated compound (3) in which R¹ is OH and the triazine chloride compound can be carried out in a solvent in the presence of N-methylmorpholine (NMM). As a result of this reaction, a triazine-based active diester can be synthesized. It is desirable that the solvent does not substantially react with the fluorinated compound (3), the triazine chloride compound, and N-methylmorpholine (NMM), has the property of dissolving the fluorinated compound (3), the triazine chloride compound, and N-methylmorpholine (NMM) well, and is a good solvent for the obtained triazine-based active diester. Such a solvent is not limited, and examples thereof include dimethyl sulfoxide (DMSO), N,N-dimethylformamide (DMF), N,N-dimethylacetamide (DMAc), N-methyl-2-pyrrolidone (NMP), 1,3-dimethylimidazolidone (DMI), sulfolane, tetrahydrofuran (THF), and acetone. Of these, N-methyl-2-pyrrolidone (NMP) is preferable. The amount of these solvents used is, based on 0.1 mol of the fluorinated compound (3) or triazine chloride compound, usually 10 to 1,000 mL, preferably 50 to 400 mL.

The reaction between the fluorinated compound (3) in which R¹ is OH and the triazine chloride compound can be carried out by, for example, dissolving any one of the fluorinated compound (3) in which R¹ is OH and the triazine chloride compound in the solvent, adding the other compound to the resulting solution, and then carrying out the reaction while stirring under an inert atmosphere such as nitrogen. The reaction temperature is preferably 50 to 150°C, and more preferably 100 to 140°C. The reaction time is preferably 0.5 to 50 hours, and more preferably 1 to 30 hours.

### <Method for producing fluorine-containing polybenzoxazole>

The fluorine-containing polybenzoxazole of the present disclosure can be suitably produced by obtaining a fluorine-containing polyamide compound by the production method described above, and then cyclodehydrating the fluorine-containing polyamide compound. Further, when producing the fluorine-containing polyamide compound, in a case in which the polymerization of the fluorinated compound (3) and the compound (4) is carried out in a heated state, a part or all of the compound undergoes cyclodehydration to form a compound having a repeating unit represented by Formula (2), which may result in the fluorine-containing polybenzoxazole of the present disclosure being obtained as a part or all of the product. That is, the present disclosure also includes mixtures of the fluorine-containing polyamide compound and the fluorine-containing polybenzoxazole.

The cyclodehydration of the fluorine-containing polyamide compound can be carried out by heating the fluorine-containing polyamide compound. The heating temperature for the cyclodehydration is preferably 110 to 450°C, and more preferably 150 to 400°C. The heating time is preferably 0.1 to 10 hours, and more preferably 0.5 to 8 hours. The cyclodehydration can be carried out in air, in a nitrogen or argon atmosphere, or under reduced pressure.

The fluorine-containing polyamide compound and the fluorine-containing polybenzoxazole of the present disclosure have a low dielectric constant and a low dielectric tangent, and thus can be suitably used as a low dielectric material.

The fluorine-containing polyamide compound and the fluorine-containing polybenzoxazole of the present disclosure have a low dielectric constant and a low dielectric tangent, and thus can be suitably used for an insulation material of a printed circuit board.

The fluorine-containing polyamide compound and the fluorine-containing polybenzoxazole of the present disclosure have a low dielectric constant and a low dielectric tangent, and thus they can be suitably used for a printed wiring board, a flexible printed circuit board, a TAB tape, a COF tape, metal wiring, and the like, as well as a material of electronic components and electronic devices, such as a cover substrate of, for example, a chip member such as metal wiring or an IC chip, a liquid crystal display, an organic electroluminescence display, electronic paper, a base substrate of a solar cell or the like.

The fluorine-containing polyamide compound and the fluorine-containing polybenzoxazole of the present disclosure have a low dielectric constant in particular at high frequencies and a low dielectric tangent, and thus can be suitably used as a material for electronic components and electronic devices that utilize high frequencies, in particular microwaves of 3 to 30 GHz. For example, the fluorine-containing polyamide compound and the fluorine-containing polybenzoxazole of the present disclosure can be suitably used as a material for an insulating plate of a high-frequency circuit, an insulating material for connecting components, a printed circuit board, a base of a high-frequency vacuum tube, an antenna cover, a coated electric wire of, for example, a coaxial cable or a LAN cable, and the like. Further, the fluorine-containing polyamide compound and the fluorine-containing polybenzoxazole of the present disclosure can be suitably used as a material for devices such as satellite communication equipment and mobile phone base stations that use microwaves of 3 to 30 GHz.

The printed circuit board is not limited, and examples thereof include printed wiring boards for electronic circuits of mobile phones, various types of computers, communication devices, and the like.

The coaxial cable is not limited, and examples thereof include coaxial cables having a structure in which an inner conductor, an insulating coating layer, an outer conductor layer, and a protective coating layer are laminated in that order from the core portion to the outer peripheral portion.

The fluorine-containing polyamide compound and the fluorine-containing polybenzoxazole of the present disclosure have a low dielectric constant and a low dielectric tangent, also have excellent heat resistance, solvent solubility, electrical insulation, and flexibility, and can be easily reduced in thickness, and thus can be suitably used for a film, a resist material, and the like. Of those,

The film can be produced by molding the fluorine-containing polyamide compound or fluorine-containing polybenzoxazole of the present disclosure by a known film molding method such as extrusion molding, calendar molding, or solution casting. Further, by casting and heating the solution containing the fluorine-containing polyamide compound of the present disclosure, it is also possible to form a film simultaneously with the formation of the fluorine-containing polybenzoxazole by cyclodehydration of the fluorine-containing polyamide compound. Moreover, the film may be subjected to a sandblasting treatment, a corona treatment, a plasma treatment, an etching treatment, or the like.

Embodiments of the present disclosure have been described above, but it will be understood that various modifications can be made to the embodiments and details thereof without departing from the gist and scope of the claims.

### EXAMPLES

Next, the embodiments of the present disclosure will be described with reference to examples, but the present disclosure is not limited to such examples.

The numerical values in the examples were measured by the following methods.

(1) Gel permeation chromatography (GPC): High-speed GPC System HLC-8220GPC, manufactured by Tosoh Corporation, column: Tosoh TSKgel α-M, eluent: N-methyl-2-pyrrolidone (NMP) including 10 mmol/L lithium bromide, column temperature: 40°C, detector : differential refractometer (RI), calibration curve: standard polystyrene
(2) Infrared spectrum (FT-IR): FT/IR-4200, manufactured by JASCO Corporation
(3) Nuclear magnetic resonance spectrum (NMR): AC400P, manufactured by BRUKER
(4) Thermogravimetric analysis (TGA): TG/DTA7300, manufactured by Hitachi High-Tech Science Corporation, temperature-increasing rate 10 °C/min
(5) Differential scanning calorimetry (DSC): DSC7000, manufactured by Hitachi High-Tech Science Corporation, temperature-increasing rate 20 °C/min
(6) Thermomechanical analysis (TMA): TMA7000, manufactured by Hitachi High-Tech Science Corporation, temperature-increasing rate 10 °C/min
(7) Dynamic viscoelasticity measurement (DMA): DMA7100, manufactured by Hitachi High-Tech Science Corporation, temperature-increasing rate 2 °C/min
(8) Tensile test: Autograph AGS-D type, manufactured by Shimadzu Corporation, tensile speed 10 mm/min
(9) Ultraviolet-visible spectrophotometer: UV-1800, manufactured by Shimadzu Corporation
(10) Refractive index measurement: Metricon Model 2010/M PRISM COUPLER
(11) Dielectric constant measurement: Dielectric constant / dielectric tangent measuring device (cavity resonator type, 10 to 20 GHz, TE mode, TM mode) manufactured by AET

### <Synthesis example 1>

### 1,6-Bis(p-methylphenyl)perfluorohexane (p-6PFBT)

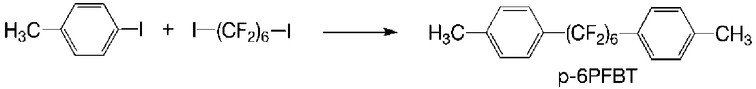

p-Iodotoluene (11.55 g, 53 mmol) and DMSO (15 mL) were charged into a 100 mL three-necked flask equipped with a stirrer, a condenser, and a nitrogen introduction tube, and made to dissolve. Next, 1,6-diiodoperfluorohexane (14.40 g, 26 mmol) and copper powder (14.17 g, 223 mmol) were added, the temperature was increased in steps to 120°C, and the mixture was reacted for 24 hours at 120°C. After completion of the reaction, the mixture was allowed to cool to room temperature, the copper powder was removed by suction filtration, and the DMSO was distilled off under reduced pressure. The obtained crude product was dissolved in diethyl ether (100 mL), and washed with distilled water. The organic layer was separated and dehydrated overnight with anhydrous sodium sulfate. The diethyl ether was distilled off with an evaporator to obtain a white product (yield amount: 11.5 g, yield: 920). The white product was recrystallized from a mixed solvent of methanol and distilled water to obtain white needle-like crystals with a melting point of 65 to 66°C.

The physical properties of the obtained product are shown below.
FT-IR (KBr, cm⁻¹): 3045 (Ar-H), 2987 (C-H), 2946 (C-H), 1615 (C=C), 1516 (C=C), 1298 (C-F), 1191 (C-F), 1147 (C-F)
¹H-NMR (CDCl₃, ppm): 2.41 (s, 6H, CH₃), 7.28 (d, 4H, Ar-H), 7.44 (d, 4H, Ar-H)
¹³C-NMR (CDCl₃, ppm): 21.49, 126.84, 129.30, 142.27
¹⁹F-NMR (CDCl₃, ppm): -122.09, -121.45, -110.50
Elemental analysis (C₂₀H₁₄F₁₂): Calculated C, 49.81%; H, 2.93%
   Measured C, 49.62%; H, 2.97%

### <Synthesis example 2>

### 1,4-Bis(p-methylphenyl)perfluorobutane (p-4PFBT)

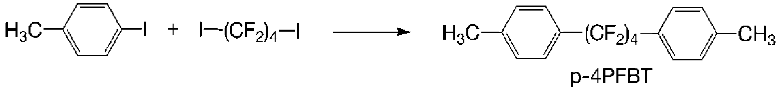

p-Iodotoluene (11.77 g, 54 mmol) and DMSO (15 mL) were charged into a 100 mL three-necked flask equipped with a stirrer, a condenser, and a nitrogen introduction tube, and made to dissolve. Next, 1,4-diiodoperfluorobutane (12.25 g, 27 mmol) and copper powder (14.17 g, 220 mmol) were added, the temperature was increased in steps to 120°C, and the mixture was reacted for 24 hours at 120°C. After completion of the reaction, the mixture was allowed to cool to room temperature, the copper powder was removed by suction filtration, and the DMSO was distilled off under reduced pressure. The obtained crude product was dissolved in diethyl ether (100 mL), and washed with distilled water. The organic layer was separated and dehydrated overnight with anhydrous sodium sulfate. The diethyl ether was distilled off with an evaporator to obtain a white product. The white product was recrystallized from a mixed solvent of methanol and distilled water to obtain white needle-like crystals. The yield amount was 1.2 g (yield: 11%). The melting point was 146 to 147°C.

The physical properties of the obtained product are shown below.
¹H-NMR (CDCl₃, ppm): 2.39 (s, 6H, CH₃), 7.26 (d, 4H, Ar-H), 7.45 (d, 4H, Ar-H)
¹³C-NMR (CDCl₃, ppm): 21.49, 126.85, 129.19, 141.98
¹⁹F-NMR (CDCl₃, ppm): -121.45, -110.31

### <Synthesis example 3>

### 1,6-Bis(m-methylphenyl)perfluorohexane (m-6PFBT)

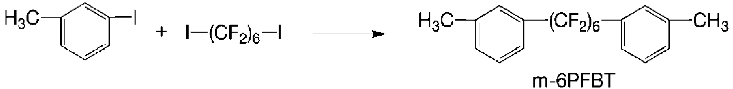

m-Iodotoluene (2.18 g, 10 mmol) and DMSO (4 mL) were charged into a 100 mL three-necked flask equipped with a stirrer, a condenser, and a nitrogen introduction tube, and made to dissolve. Next, 1,6-diiodoperfluorohexane (2.79 g, 5 mmol) and copper powder (3.43 g, 54 mmol) were added, the temperature was increased in steps to 120°C, and the mixture was reacted for 24 hours at 120°C. After completion of the reaction, the mixture was allowed to cool to room temperature, the copper powder was removed by suction filtration, and the DMSO was distilled off under reduced pressure. The obtained crude product was dissolved in diethyl ether (100 mL), and washed with distilled water. The organic layer was separated and dehydrated overnight with anhydrous sodium sulfate. The diethyl ether was distilled off with an evaporator to obtain a liquid product. A colorless transparent liquid was obtained by vacuum distillation (150°C/0.8 Torr). The yield amount was 1.3 g (yield: 55%).

The physical properties of the obtained product are shown below.
¹H-NMR (CDCl₃, ppm): 2.41 (s, 6H, CH₃), 7.35-7.38 (m, 8H, Ar-H) ¹³C-NMR (CDCl₃, ppm): 21.14, 124.10, 127.39, 128.51, 129.32, 132.61, 138.62
¹⁹F-NMR (CDCl₃, ppm): -121.76, -121.28, -110.51
Elemental analysis (C₂₀H₁₄F₁₂): Calculated C, 49.81%; H, 2.93%
   Measured C, 49.55%; H, 2.98%

### <Synthesis example 4>

### 1,6-Bis(p-carboxyphenyl)perfluorohexane (p-6PFBBA)

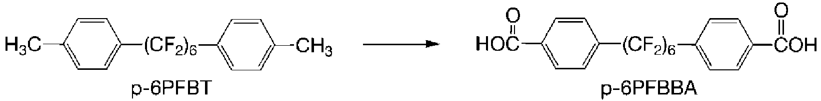

p-6PFBT (10.61 g, 22 mmol), acetic acid (180 mL), and concentrated sulfuric acid (18 mL) were charged into a 500 mL three-necked flask equipped with a stirrer, a nitrogen introduction tube, a thermometer, and a dropping funnel, made to dissolve, and the resulting mixture was cooled to 0°C. A solution prepared by dissolving chromium trioxide (17.4 g, 174 mmol) in acetic anhydride (77 mL) was added dropwise, and after the addition was completed, the mixture was reacted for 12 hours at room temperature while stirring. After completion of the reaction, the reaction solution was charged into distilled water (1 L) to precipitate a product. The product was collected in the form of a white powder by suction filtration, and dried under reduced pressure for 12 hours at 80°C. The dried product was recrystallized from a mixed solvent of DMF / distilled water, and dried under reduced pressure for 12 hours at 100°C to obtain white powdery crystals. The yield amount was 9.7 g (yield: 81%).

The physical properties of the obtained product are shown below.
FT-IR (KBr, cm⁻¹): 3147-2613 (O-H), 1699 (C=O), 1582 (C=C), 1516 (C=C), 1292 (C-F), 1214 (C-F), 1134 (C-F)
¹H-NMR (DMSO-d₆, ppm): 7.80 (d, 4H, Ar-H), 8.13 (d, 4H, Ar-H), 13.44 (s, 2H, COOH)
¹³C-NMR (DMSO-d₆, ppm): 127.69, 130.49,131.67, 135.30, 166.76 ¹⁹F-NMR (DMSO-d₆, ppm): -121.97, -121.52, -110.42
Elemental analysis (C₂₀H₁₀F₁₂O₄): Calculated C, 44.30%; H, 1.86%
   Measured C, 44.09%; H, 1.97%

### <Synthesis example 5>

### 1,4-Bis(p-carboxyphenyl)perfluorobutane (p-4PFBBA)

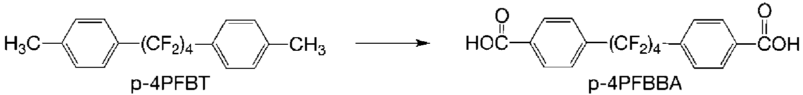

p-4PFBT (1.84 g, 4.8 mmol), acetic acid (55 mL), and concentrated sulfuric acid (5.5 mL) were charged into a 500 mL three-necked flask equipped with a stirrer, a nitrogen introduction tube, a thermometer, and a dropping funnel, made to dissolve, and the resulting mixture was cooled to 0°C. A solution prepared by dissolving chromium trioxide (5.2 g, 52 mmol) in acetic anhydride (30 mL) was added dropwise, and after the addition was completed, the mixture was reacted for 12 hours at room temperature while stirring. After completion of the reaction, the reaction solution was charged into distilled water (500 mL) to precipitate a white product. The white product was collected by suction filtration, and dried under reduced pressure for 12 hours at 80°C. The yield amount was 1.1 g (yield: 52%).

The physical properties of the obtained product are shown below.
FT-IR (KBr, cm⁻¹): 3300-2500 (O-H), 1698 (C=O), 1579 (C=C), 1515 (C=C), 1291 (C-F), 1199 (C-F), 1133 (C-F)
¹H-NMR (DMSO-d₆, ppm): 7.75 (d, 4H, Ar-H), 8.09 (d, 4H, Ar-H), 13.48 (s, 2H, COOH)
¹³C-NMR (DMSO-d₆, ppm): 127.63, 130.39, 132.22, 135.05, 166.79 ¹⁹F-NMR (DMSO-d₆, ppm): -121.01, -109.95

### <Synthesis example 6>

### 1,6-Bis(m-carboxyphenyl)perfluorohexane (m-6PFBBA)

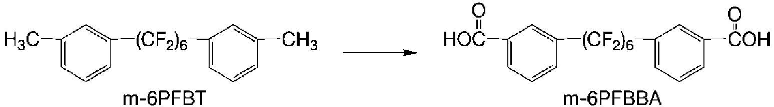

m-6PFBT (1.12 g, 2.3 mmol), acetic acid (50 mL), and concentrated sulfuric acid (5 mL) were charged into a 500 mL three-necked flask equipped with a stirrer, a nitrogen introduction tube, a thermometer, and a dropping funnel, made to dissolve, and the resulting mixture was cooled to 0°C. A solution prepared by dissolving chromium trioxide (5.4 g, 54 mmol) in acetic anhydride (30 mL) was added dropwise, and after the addition was completed, the mixture was reacted for 12 hours at room temperature while stirring. After completion of the reaction, the reaction solution was charged into distilled water (500 mL) to precipitate a product. The product was collected in the form of a white powder by suction filtration, and dried under reduced pressure for 12 hours at 80°C. The yield amount was 1.0 g (yield: 83%). The melting point was 269 to 270°C.

The physical properties of the obtained product are shown below.
FT-IR (KBr, cm⁻¹): 3400-2600 (O-H), 1700 (C=O), 1614 (C=C), 1290 (C-F), 1194 (C-F), 1135 (C-F)
¹H-NMR (DMSO-d₆, ppm): 7.74-7.77 (m, 2H, Ar-H), 7.93 (d, 2H, Ar-H), 8.08 (s, 2H, Ar-H), 8.22 (d, 2H, Ar-H), 13.55 (s, 2H, COOH) ¹³C-NMR (DMSO-d₆, ppm): 127.48, 128.43, 130.63, 131.51, 132.38, 133.98, 166.54
¹⁹F-NMR (DMSO-d₆, ppm): -121.47, -121.00, -109.70
Elemental analysis (C₂₀H₁₀F₁₂O₄): Calculated C, 44.30%; H, 1.86%
   Measured C, 43.95%; H, 2.08%

### <Synthesis example 7>

### 1,6-Bis(p-chlorocarbonylphenyl)perfluorohexane (p-6PFBBC)

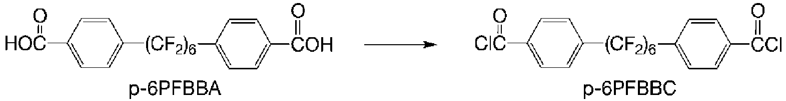

p-6PFBBA (5.38 g, 9.9 mmol) and thionyl chloride (40 mL) were charged into an eggplant flask (100 mL) equipped with a stirrer, a condenser, and a calcium chloride tube. The temperature was then slowly raised to 85°C, and the mixture was stirred for 1 hour. The mixture was allowed to cool to room temperature, and excess thionyl chloride was distilled off under reduced pressure to obtain a solid product. The obtained solid product was purified by sublimation (140°C/0.8 Torr) to obtain white needle-like crystals (yield amount: 4.4 g, yield: 77%). The melting point was 129 to 130°C.

The physical properties of the obtained product are shown below.
FT-IR (KBr, cm⁻¹): 3064 (Ar-H), 1746 (C=O), 1146 (C-F) ¹H-NMR (CDCl₃, ppm): 7.75 (d, 4H, Ar-H), 8.24 (d, 4H, Ar-H) ¹³C-NMR (CDCl₃, ppm): 127.78, 131.40, 135.49, 136.44, 167.76 ¹⁹F-NMR (CDCl₃, ppm): -121.60, -121.10, -111.33
Elemental analysis (C₂₀H₈Cl₂F₁₂O₂): Calculated C, 41.48%; H, 1.39%
   Measured C, 41.43%; H, 1.48%

### <Synthesis example 8>

### 1,4-Bis(p-chlorocarbonylphenyl)perfluorobutane (p-4PFBBC)

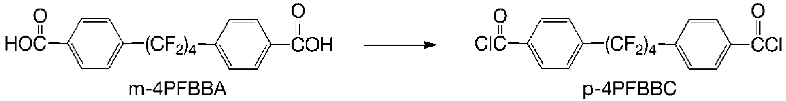

A solid product was obtained in the same manner as in synthesis example 7 by reacting p-4PFBBA and thionyl chloride. The obtained solid product was purified by sublimation to obtain white needle-like crystals. The melting point was 109 to 110°C.

The physical properties of the obtained product are shown below.
FT-IR (KBr, cm⁻¹): 3063 (Ar-H), 1746 (C=O), 1142 (C-F) ¹H-NMR (CDCl₃, ppm): 7.70 (d, 4H, Ar-H), 8.20 (d, 4H, Ar-H) ¹⁹F-NMR (CDCl₃, ppm): -121.31, -110.35

### <Synthesis example 9>

### Bis(4,6-dimethoxy-1,3,5-triazin-2-yl)-p-dodecafluorohexylenedibenzoate (p-DFBBT)

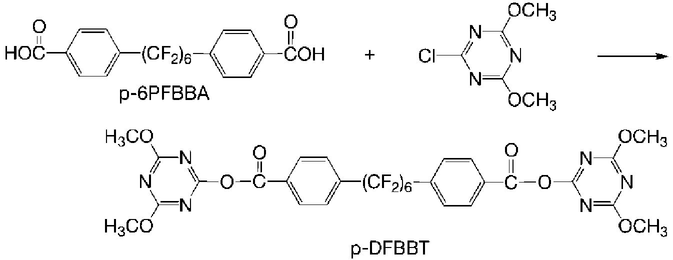

p-6PFBBA (27.11 g, 50 mmol), chlorodimethoxytriazine (CDMT) (17.51 g, 100 mmol), and NMP (400 mL) were charged into a 500 mL three-necked flask equipped with a stirrer, a nitrogen introduction tube, and a thermometer, made to dissolve, and the resulting mixture was cooled to 0°C. Then, N-methylmorpholine (NMM) (11.59 mL, 105 mmol) was added, and the mixture was reacted for 1 hour at 0°C. After completion of the reaction, the reaction solution was charged into 400 mL of an aqueous solution adjusted to pH 3 using acetic acid to precipitate a product. The product was collected by suction filtration and dried under reduced pressure for 12 hours at 50°C. The crude yield amount was 32.8 g (crude yield 80%). The dried crude product was recrystallized from a mixed solvent of chloroform / hexane, and dried under reduced pressure for 12 hours at 50°C to obtain a product in the form of a white powder (yield amount: 21.33 g, yield: 52%).

The physical properties of the obtained product are shown below.
¹H-NMR (CDCl₃, ppm): 4.09 (s, 12H, CH₃), 7.76 (d, 4H, Ar-H), 8.30 (d, 4H, Ar-H)
¹³C-NMR (CDCl₃, ppm): 56.20, 127.64, 130.90, 131.61, 137.01, 137.10, 139.19, 161.54, 170.70, 171.13, 174.39
¹⁹F-NMR (CDCl₃, ppm): -123.10, -122.53, -112.65

### <Synthesis example 10>

### 1,4-Bis(p-methylphenyl)perfluorobutane (p-4PFBT)

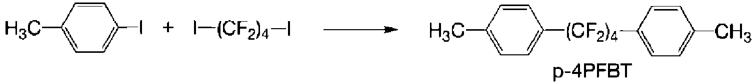

p-Iodotoluene (20.46 g, 94 mmol) and DMSO (65 mL) were charged into a 100 mL three-necked flask equipped with a stirrer, a condenser, and a nitrogen introduction tube, and made to dissolve. Next, 1,4-diiodoperfluorobutane (21.27 g, 47 mmol), 2,2-bipyridyl (3.01 g, 19 mmol) and copper powder (21.37 g, 336 mmol) were added, the temperature was increased in steps to 70°C, and the mixture was reacted for 48 hours at 70°C. After completion of the reaction, the mixture was allowed to cool to room temperature, the copper powder was removed by suction filtration, and the DMSO was distilled off by under reduced pressure. The obtained crude product was dissolved in diethyl ether (100 mL), and washed with distilled water. The organic layer was separated and dehydrated overnight with anhydrous sodium sulfate. The diethyl ether was distilled off with an evaporator to obtain a pale green product. The pale green product was recrystallized from a mixed solvent of ethyl acetate and hexane to obtain white needle-like crystals. The yield amount was 8.8 g (48% yield), and the melting point was 146 to 147°C.

The physical properties of the obtained product are shown below.
FT-IR (KBr, cm⁻¹): 3046 (Ar-H), 2987 (C-H), 2946 (C-H), 1615 (C=C), 1516 (C=C), 1298 (C-F), 1191 (C-F), 1147 (C-F)
¹H-NMR (CDCl₃, ppm): 2.39 (s, 6H, CH₃), 7.27 (d, 4H, Ar-H), 7.44 (d, 4H, Ar-H)
¹³C-NMR (CDCl₃, ppm): 21.49, 126.85, 129.19, 141.98
¹⁹F-NMR (CDCl₃, ppm): -121.45, -110.31
Elemental analysis (C₁₈H₁₄F₈) : Calculated C, 56.55%; H, 3.69%
   Measured C, 56.21%; H, 3.72%

### <Synthesis example 11>

### 1,6-Bis(m-chlorocarbonylphenyl)perfluorohexane (m-6PFBBC)

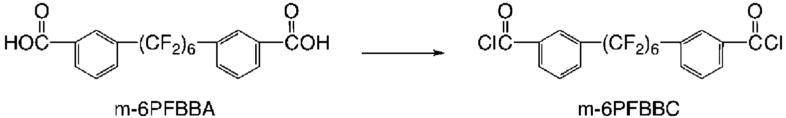

A solid product was obtained in the same manner as in synthesis example 7 by reacting m-6PFBBA (7.4 g, 14 mmol) and thionyl chloride (40 mL). The obtained solid product was purified by vacuum distillation to obtain white crystals. The yield amount was (5.8 g) (yield: 720). The melting point was 38 to 39°C.

The physical properties of the obtained product are shown below.
FT-IR (KBr, cm⁻¹): 3063 (Ar-H), 1746 (C=O), 1142 (C-F)
Elemental analysis (C₂₀H₈Cl₂F₁₂O₂): Calculated C, 41.48%; H, 1.39%
   Measured C, 41.31%; H, 1.49%

### <Synthesis example 12>

### 1,6-Bis(p-carboxyphenyl)perfluorohexane (p-6PFBBA)

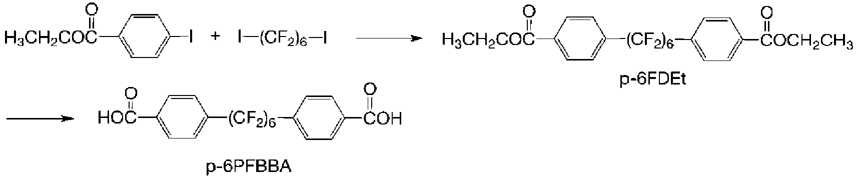

Ethyl p-iodobenzoate (2.01 g, 7.3 mmol) and DMSO (20 mL) were charged into a 100 mL three-necked flask equipped with a stirrer, a condenser, and a nitrogen introduction tube, and made to dissolve. Next, 1,6-diiodoperfluorohexane (2.01 g, 3.6 mmol), 2,2'-bipyridyl (0.24 g, 1.5 mmol), and copper powder (2.30 g, 36 mmol) were added, the temperature was increased in steps to 120°C, and the mixture was reacted for 24 hours at 120°C. After completion of the reaction, the mixture was allowed to cool to room temperature, the reaction solution was charged into distilled water (600 mL) to precipitate a product and the copper powder. The precipitate was collected by suction filtration and dried under reduced pressure at 60°C for 12 hours. Toluene (100 mL) was added to the dried precipitate, the mixture was heated under reflux, the copper powder was removed by filtration while hot, and the toluene was distilled off from the filtrate to obtain p-6FDEt. The obtained p-6FDEt was recrystallized from toluene to obtain white plate-like crystals. The yield amount was 1.36 g (63% yield), and the melting point was 100 to 101°C.

The physical properties of the obtained p-6FDEt are shown below.
¹H-NMR (CDCl₃, ppm): 1.40-1.43 (t, 6H, CH₃), 4.40-4.44 (q, 4H, CH₂), 7.66-7.68 (d, 4H, Ar-H), 8.16-8.17 (d, 4H, Ar-H)
¹³C-NMR (CDCl₃, ppm): 14.4, 61.7, 127.1, 129.8, 165.6
¹⁹F-NMR (CDCl₃, ppm): -121.8, -121.1, -111.0

7 g of a 50 wt% aqueous potassium hydroxide solution and methanol (20 mL) were added to p-6FDEt (1.30 g, 2.2 mmol), and the mixture was heated under reflux for 12 hours. After cooling to room temperature, distilled water was added to dilute the mixture, insoluble matter was filtered off, and then concentrated hydrochloric acid was added to make the filtrate acidic. The precipitated p-6PFBBA was collected by suction filtration, washed with distilled water, and then recrystallized from a mixed solvent of DMF and distilled water to obtain white powder crystals. The yield amount was 0.95 g (80% yield).

### <Synthesis example 13>

### 1,6-Bis(p-carboxyphenyl)perfluorohexane (p-6PFBBA)

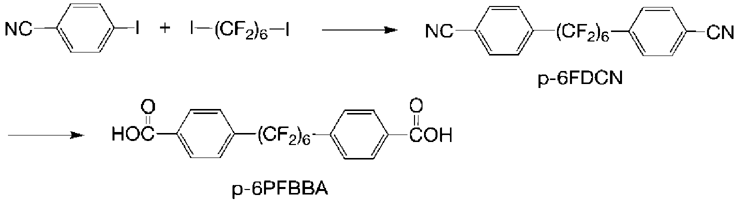

p-Iodobenzonitrile (1.82 g, 7.9 mmol) and DMSO (20 mL) were charged into a 100 mL three-necked flask equipped with a stirrer, a condenser, and a nitrogen introduction tube, and made to dissolve. Next, 1,6-diiodoperfluorohexane (2.20 g, 4.0 mmol), 2,2'-bipyridyl (0.25 g, 1.6 mmol), and copper powder (2.52 g, 40 mmol) were added, the temperature was increased in steps to 120°C, and the mixture was reacted for 24 hours at 120°C. After completion of the reaction, the mixture was allowed to cool to room temperature, the reaction solution was charged into distilled water (600 mL) to precipitate a product and the copper powder. The precipitate was collected by suction filtration and dried under reduced pressure at 60°C for 12 hours. Toluene (100 mL) was added to the dried precipitate, the mixture was heated under reflux, the copper powder was removed by filtration while hot, and the toluene was distilled off from the filtrate to obtain p-6FDCN. The obtained p-6FDCN was recrystallized from toluene to obtain white crystals. The yield amount was 0.78 g (39% yield), and the melting point was 154 to 155°C.

The physical properties of the obtained p-6FDCN are shown below.
¹H-NMR (CDCl₃, ppm): 7.72-7.74 (d, 4H, Ar-H), 7.82-7.83 (d, 4H, Ar-H)

4 g of a 50 wt% aqueous potassium hydroxide solution and methanol (10 mL) were added to p-6FDCN (0.70 g, 1.4 mmol), and the mixture was heated under reflux for 12 hours. After cooling to room temperature, distilled water was added to dilute the mixture, insoluble matter was filtered off, and then concentrated hydrochloric acid was added to make the filtrate acidic. The precipitated p-6PFBBA was collected by suction filtration, washed with distilled water, and then recrystallized from a mixed solvent of DMF and distilled water to obtain white powder crystals. The yield amount was 0.68 g (89% yield).

### <Example 1>

### Fluorinated polyamide compound (p-6PFBBC/6FAP) and fluorinated polybenzoxazole (p-6PFBBC/6FAP)

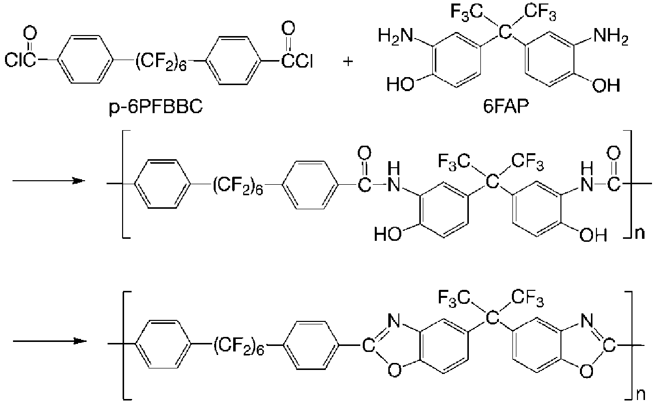

A stirrer was placed in a three-necked flask (100 mL) equipped with a nitrogen introduction tube. After heating and drying with a heat gun, 6FAP (0.70 g, 1.9 mmol) and NMP (5 mL) purified by distillation were added, and the mixture was stirred to dissolve. Then, a silylating agent BSA (0.77 g, 3.8 mmol) was added and reacted at room temperature for 1 hour. The reaction solution was solidified with liquid nitrogen, p-6PFBBC (1.10 g, 1.9 mmol) was added, and the mixture was stirred at room temperature for 8 hours to react. The polymerization solution was charged into distilled water (400 mL) to precipitate a fluorinated polyamide compound (p-6PFBBC/6FAP). The precipitated polyamide was collected by suction filtration and dried under reduced pressure at 80°C for 12 hours. The yield amount was 1.24 g (75% yield).

The polyamide was dissolved in distilled and purified NMP to prepare a 20 wt% solution. This solution was cast onto a glass plate, dried under reduced pressure at room temperature for 3 hours, and then heat treated under reduced pressure at 60°C for 3 hours, 100°C for 3 hours, 150°C for 1 hour, 200°C for 1 hour, 250°C for 1 hour, and 300°C for 1 hour to obtain a brown transparent cast film (thickness: 30 µm).

The properties of the polyamide are shown below.
FT-IR (KBr, cm⁻¹): 3414 (N-H), 1667 (C=O), 1134 (C-F)
Logarithmic viscosity (ηᵢₙₕ): 0.73 dL/g (NMP solution having a 0.5 g/dL concentration, measured at 30°C)
Number average molecular weight (Mn): 71,000
Weight average molecular weight (Mw): 135,000
Molecular weight distribution (Mw/Mn): 1.9
Solubility (10 wt%): Soluble in NMP, DMAc, THF, and TMU

The properties of the polybenzoxazole are shown below. FT-IR (KBr, cm⁻¹): 1560 (C=N), 1140 (C-F)
Elemental analysis (C₃₅H₁₄F₁₈N₂O₂):
   Calculated C, 50.26%; H, 1.69%; N, 3.35%
   Measured C, 50.12%; H, 1.87%; N, 3.42%
Solubility: Insoluble in organic solvents
5% Weight loss temperature: 497°C (in air), 520°C (in nitrogen) (TGA)
10% Weight loss temperature: 518°C (in air), 539°C (in nitrogen) (TGA)
Carbonization yield: 56% (800°C in nitrogen) (TGA)
Glass transition temperature: 210°C (DSC), 213°C (TMA), 210°C (DMA)
Thermal expansion coefficient: 97 ppm/°C (50 to 100°C)
Tensile strength: 48 MPa
Elongation at break: 8%
Tensile elasticity: 1.9 GPa
Cut-off wavelength: 335 nm
Transmission at 500 nm: 73%
Average refractive index (nₐᵥₑ): 1.540 (d line)
Birefringence (Δn): 0.002 (d line) Dielectric constant (ε) calculated from refractive index: 2.37 (ε = nₐᵥₑ²)
Dielectric constant (Dₖ): 2.34 (10 GHz, TE mode), 2.33 (10 GHz, TM mode), 2.33 (20 GHz, TE mode)
Dielectric tangent (D_{f}): 0.0014 (10 GHz, TE mode), 0.0016 (10 GHz, TM mode), 0.0018 (20 GHz, TE mode)

### <Example 2>

### Fluorinated polyamide compound (p-4PFBBC/6FAP) and fluorinated polybenzoxazole (p-4PFBBC/6FAP)

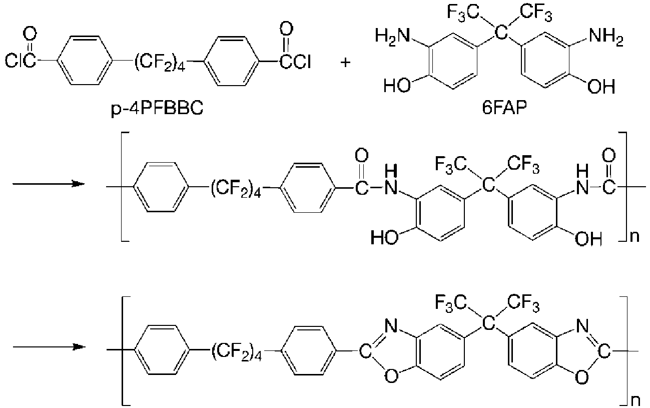

A stirrer was placed in a three-necked flask (100 mL) equipped with a nitrogen introduction tube. After heating and drying with a heat gun, 6FAP (0.70 g, 1.9 mmol) and distilled NMP (5 mL) were added, and the mixture was stirred to dissolve. Then, a silylating agent BSA (0.77 g, 3.8 mmol) was added and reacted at room temperature for 1 hour. The reaction solution was solidified with liquid nitrogen, p-4PFBBC (0.91 g, 1.9 mmol) was added, and the mixture was stirred at room temperature for 8 hours to react. The polymerization solution was charged into distilled water (400 mL) to precipitate a fluorinated polyamide compound (p-4PFBBC/6FAP). The precipitated polyamide was collected by suction filtration and dried under reduced pressure at 80°C for 12 hours.

The polyamide was dissolved in distilled NMP to prepare a 20 wt% solution. The solution was cast onto a glass plate, dried under reduced pressure at room temperature for 3 hours, and then heat treated under reduced pressure at 60°C for 3 hours, 100°C for 3 hours, 150°C for 1 hour, 200°C for 1 hour, 250°C for 1 hour, and 300°C for 1 hour to obtain a brown transparent cast film (thickness: 26 µm).

The properties of the polyamide are shown below. FT-IR (KBr, cm⁻¹): 3414 (N-H), 1667 (C=O), 1134 (C-F) Logarithmic viscosity (ηᵢₙₕ): 0.34 dL/g (NMP solution having a 0.5 g/dL concentration, measured at 30°C)
Solubility (10 wt%): Soluble in NMP, DMAc, THF, and TMU
The properties of the polybenzoxazole are shown below.
FT-IR (KBr, cm⁻¹) : 1560 (C=N), 1140 (C-F)
Elemental analysis (C₃₃H₁₄F₁₄N₂O₂):
   Calculated C, 53.82%; H, 1.92%; N, 3.80%
   Measured C, 53.81%; H, 2.12%; N, 4.00%
Solubility: Insoluble in organic solvents
5% Weight loss temperature: 467°C (in air), 513°C (in nitrogen) (TGA)
10% Weight loss temperature: 500°C (in air), 533°C (in nitrogen) (TGA)
Carbonization yield: 53% (800°C in nitrogen) (TGA)
Glass transition temperature: 226°C (TMA), 228°C (DMA)
Thermal expansion coefficient: 83 ppm/°C (80 to 120°C)
Cut-off wavelength: 335 nm
Transmission at 500 nm: 80%
Average refractive index (nₐᵥₑ): 1.560 (d line)
Birefringence (Δn): 0.002 (d line)
Dielectric constant (ε) calculated from refractive index: 2.43 (ε = nₐᵥₑ²)
Dielectric constant (Dₖ): 2.56 (10 GHz, TE mode), 2.46 (10 GHz, TM mode), 2.61 (20 GHz, TE mode)
Dielectric tangent (D_{f}): 0.0021 (10 GHz, TE mode), 0.0021 (10 GHz, TM mode), 0.0018 (20 GHz, TE mode)

### <Example 3>

### Fluorinated polyamide compound (p-6PFBBC/HAB) and fluorinated polybenzoxazole (p-6PFBBC/HAB)

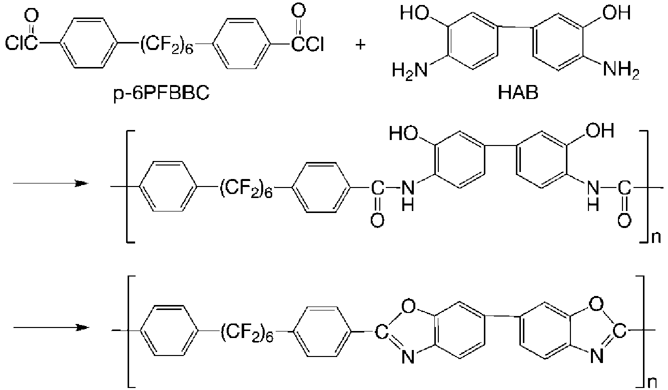

A stirrer was placed in a three-necked flask (100 mL) equipped with a nitrogen introduction tube. After heating and drying with a heat gun, HAB (0.41 g, 1.9 mmol) and distilled NMP (5 mL) were added, and the mixture was stirred to dissolve. Then, a silylating agent BSA (0.77 g, 3.8 mmol) was added and reacted at room temperature for 1 hour. The reaction solution was solidified with liquid nitrogen, p-6PFBBC (1.10 g, 1.9 mmol) was added, and the mixture was stirred at room temperature for 8 hours to obtain a solution of a fluorinated polyamide compound (p-6PFBBC/6FAP). This polymerization solution was cast onto a glass plate, and then heat treated under reduced pressure at room temperature for 3 hours, 60°C for 3 hours, 100°C for 3 hour, 150°C for 1 hour, 200°C for 1 hour, 250°C for 1 hour, 300°C for 1 hour, and 400°C for 30 minutes to obtain a brown cast film (thickness: 24 µm) of a fluorinated polybenzoxazole (p-6PFBBC/HAB) .

The properties of the polyamide are shown below. FT-IR (KBr, cm⁻¹): 3413 (N-H), 1662 (C=O), 1139 (C-F)

The properties of the polybenzoxazole are shown below.
FT-IR (KBr, cm⁻¹): 1599 (C=N), 1139 (C-F)
Elemental analysis (C₃₂H₁₄F₁₂N₂O₂):
   Calculated C, 55.99%; H, 2.06%; N, 4.08%
   Measured C, 56.57%; H, 2.28%; N, 4.11%
Solubility: Insoluble in organic solvents
5% Weight loss temperature: 486°C (in air), 534°C (in nitrogen) (TGA)
10% Weight loss temperature: 515°C (in air), 559°C (in nitrogen) (TGA)
Carbonization yield: 54% (800°C in nitrogen) (TGA)
Glass transition temperature: 246°C (DMA)
Thermal expansion coefficient: 66 ppm/°C (60 to 120°C)
Dielectric constant (Dₖ): 2.60 (10 GHz, TE mode), 2.67 (10 GHz, TM mode), 2.61 (20 GHz, TE mode)
Dielectric tangent (D_{f}): 0.0013 (10 GHz, TE mode), 0.0013 (10 GHz, TM mode), 0.0014 (20 GHz, TE mode)

### <Example 4>

### Fluorinated polyamide compound (p-6PFBBC/APP) and fluorinated polybenzoxazole (p-6PFBBC/APP)

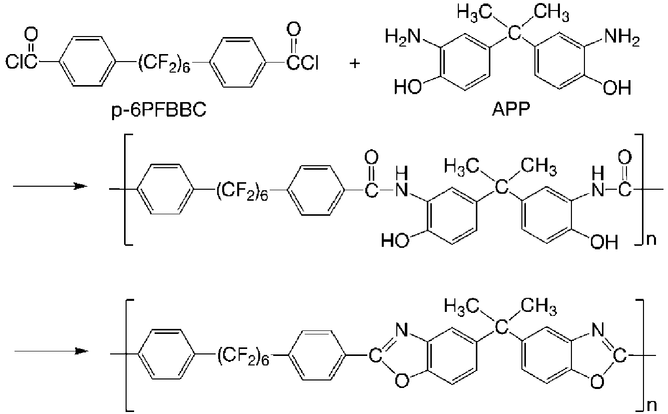

A polyamide was synthesized in the same manner as in Example 1 except that APP was used instead of 6FAP, and the polyamide was then heat treated at 300°C for 1 hour to produce a polybenzoxazole film (brown, transparent, thickness: 35 µm).

The properties of the polyamide are shown below.
FT-IR (KBr, cm⁻¹): 3414 (N-H), 1655 (C=O), 1134 (C-F)
Logarithmic viscosity (ηᵢₙₕ): 0.45 dL/g (NMP solution having a 0.5 g/dL concentration, measured at 30°C)
Number average molecular weight (Mn): 48,000
Weight average molecular weight (Mw): 96,000
Molecular weight distribution (Mw/Mn): 2.0
Solubility (10 wt%): Soluble in NMP, DMAc, THF, and TMU

The properties of the polybenzoxazole are shown below.
FT-IR (KBr, cm⁻¹) : 1559 (C=N), 1140 (C-F)
Solubility: Insoluble in organic solvents
5% Weight loss temperature: 439°C (in air), 493°C (in nitrogen) (TGA)
10% Weight loss temperature: 457°C (in air), 510°C (in nitrogen) (TGA)
Carbonization yield: 55% (800°C in nitrogen) (TGA)
Glass transition temperature: 175°C (TMA), 171°C (DMA)
Thermal expansion coefficient: 95 ppm/°C (60 to 160°C)
Cut-off wavelength: 351 nm
Transmission at 500 nm: 72%
Average refractive index (nₐᵥₑ): 1.580 (d line)
Birefringence (Δn): 0.002 (d line)
Dielectric constant (ε) calculated from refractive index: 2.50 (ε = nₐᵥₑ²)
Dielectric constant (Dₖ): 2.54 (10 GHz, TE mode), 2.52 (10 GHz, TM mode), 2.51 (20 GHz, TE mode)
Dielectric tangent (D_{f}): 0.0022 (10 GHz, TE mode), 0.0022 (10 GHz, TM mode), 0.0021 (20 GHz, TE mode)

### <Example 5>

### Fluorinated polyamide compound (m-6PFBBC/HAB) and fluorinated polybenzoxazole (m-6PFBBC/HAB)

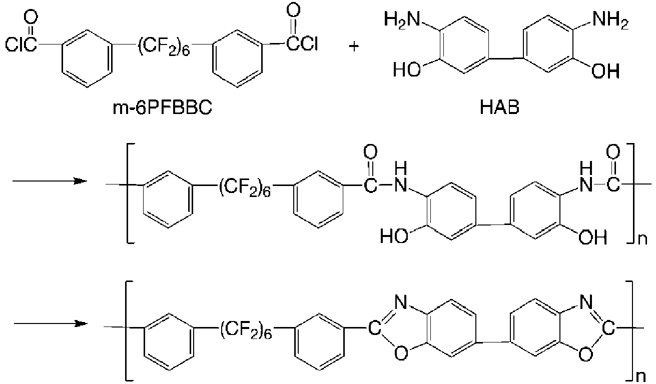

A polyamide was synthesized in the same manner as in Example 3 except that m-6PFBBC was used instead of p-6PFBBC, and the polyamide was then heat treated at 350°C for 1 hour to produce a polybenzoxazole film (brown, transparent, thickness: 40 µm).

The properties of the polyamide are shown below.
FT-IR (KBr, cm⁻¹): 3414 (N-H), 1660 (C=O), 1134 (C-F)
Logarithmic viscosity (ηᵢₙₕ): 0.47 dL/g (NMP solution having a 0.5 g/dL concentration, measured at 30°C)
Solubility (10 wt%): Soluble in NMP, DMAc, and TMU

The properties of the polybenzoxazole are shown below.
FT-IR (KBr, cm⁻¹) : 1559 (C=N), 1140 (C-F)
Solubility: Insoluble in organic solvents
5% Weight loss temperature: 476°C (in air), 512°C (in nitrogen) (TGA)
10% Weight loss temperature: 509°C (in air), 541°C (in nitrogen) (TGA)
Carbonization yield: 59% (800°C in nitrogen) (TGA)
Glass transition temperature: 227°C (TMA), 225°C (DMA)
Thermal expansion coefficient: 68 ppm/°C (100 to 200°C)
Average refractive index (nₐᵥₑ): 1.645 (d line)
Birefringence (Δn): 0.004 (d line)
Dielectric constant (ε) calculated from refractive index: 2.70 (ε = nₐᵥₑ²)
Dielectric constant (Dₖ): 2.63 (10 GHz, TE mode), 2.63 (10 GHz, TM mode), 2.64 (20 GHz, TE mode)
Dielectric tangent (D_{f}): 0.0027 (10 GHz, TE mode), 0.0029 (10 GHz, TM mode), 0.0026(20 GHz, TE mode)

### <Example 6>

### Fluorinated polyamide compound (p-6PFBBC/m-6PFBBC/6-FAP) and fluorinated polybenzoxazole (p-6PFBBC/m-6PFBBC/6-FAP)

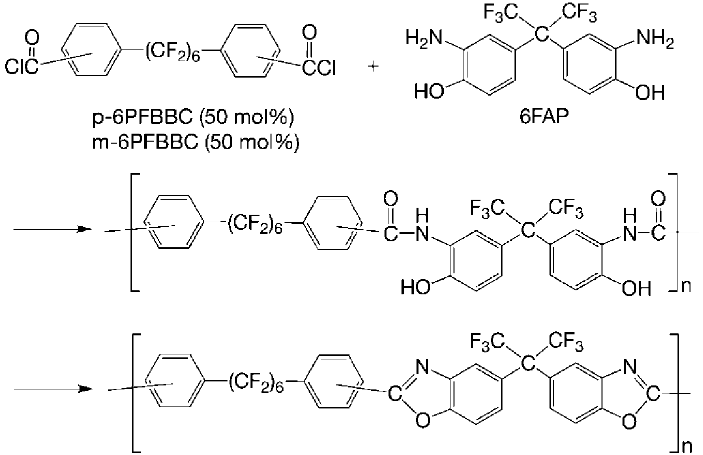

A polyamide was synthesized in the same manner as in Example 1 except that p-6PFBBC (50 mol%) and m-6PFBBC (50 mol%) were used instead of p-6PFBBC, and the polyamide was then heat treated at 300°C for 1 hour to produce a polybenzoxazole film (brown, transparent, thickness: 28 µm).

The properties of the polyamide are shown below. Logarithmic viscosity (ηᵢₙₕ): 0.32 dL/g (NMP solution having a 0.5 g/dL concentration, measured at 30°C)

The properties of the polybenzoxazole are shown below. 5% Weight loss temperature: 463°C (in air), 499°C (in nitrogen) (TGA)
10% Weight loss temperature: 489°C (in air), 523°C (in nitrogen) (TGA)
Carbonization yield: 50% (800°C in nitrogen) (TGA)
Glass transition temperature: 192°C (TMA), 191°C (DMA)
Thermal expansion coefficient: 84 ppm/°C (80 to 160°C)
Average refractive index (nₐᵥₑ): 1.541 (d line)
Birefringence (Δn): 0.002 (d line)
Dielectric constant (ε) calculated from refractive index: 2.38 (ε = nₐᵥₑ²)
Dielectric constant (Dₖ): 2.35 (10 GHz, TE mode), 2.37 (10 GHz, TM mode), 2.37 (20 GHz, TE mode)
Dielectric tangent (D_{f}): 0.0020 (10 GHz, TE mode), 0.0021 (10 GHz, TM mode), 0.0021 (20 GHz, TE mode)

### <Comparative Example 1>

### Fluorinated polyamide compound (p-6FDC/6FAP) and fluorinated polybenzoxazole (p-6FDC/6FAP)

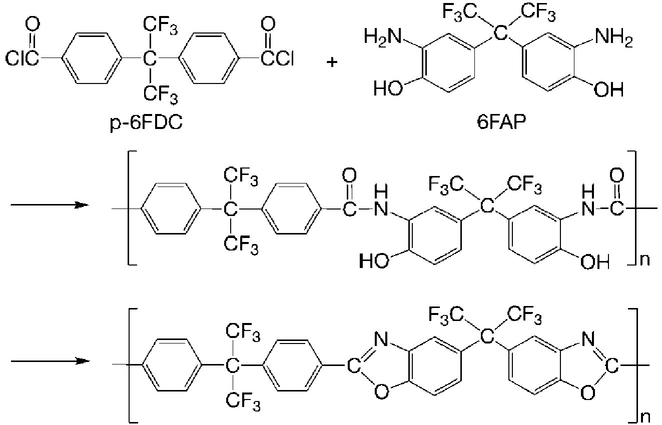

A polyamide was synthesized in the same manner as in Example 1 except that p-6FDC was used instead of p-6PFBBC, and the polyamide was then heat treated at 350°C for 1 hour to produce a polybenzoxazole film (pale-yellow, transparent, thickness: 58 µm).

The properties of the polyamide are shown below.
Logarithmic viscosity (ηᵢₙₕ): 0.58 dL/g (NMP solution having a 0.5 g/dL concentration, measured at 30°C)
Number average molecular weight (Mn): 51,000
Weight average molecular weight (Mw): 97,000
Molecular weight distribution (Mw/Mn): 1.9

The properties of the polybenzoxazole are shown below.
5% Weight loss temperature: 489°C (in air), 512°C (in nitrogen) (TGA)
10% Weight loss temperature: 512°C (in air), 531°C (in nitrogen) (TGA)
Carbonization yield: 55% (800°C in nitrogen) (TGA)
Glass transition temperature: 299°C (TMA), 309°C (DMA)
Thermal expansion coefficient: 62 ppm/°C (60 to 200°C)
Average refractive index (nₐᵥₑ): 1.560 (d line)
Birefringence (Δn): 0.000 (d line)
Dielectric constant (ε) calculated from refractive index: 2.43 (ε - nₐᵥₑ²)
Dielectric constant (Dₖ): 2.44 (10 GHz, TE mode), 2.44 (10 GHz, TM mode), 2.39 (20 GHz, TE mode)
Dielectric tangent (D_{f}): 0.0046 (10 GHz, TE mode), 0.0053 (10 GHz, TM mode), 0.0045 (20 GHz, TE mode)

### <Comparative Example 2>

### Fluorinated polyamide compound (p-6FDC/APP) and fluorinated polybenzoxazole (p-6FDC/APP)

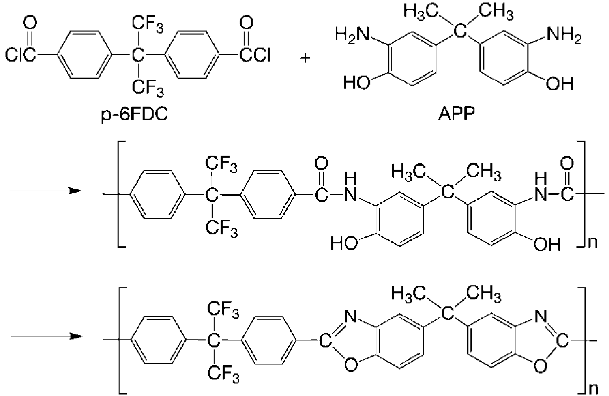

A polyamide was synthesized in the same manner as in Example 4 except that p-6FDC was used instead of p-6PFBBC, and the polyamide was then heat treated at 350°C for 1 hour to produce a polybenzoxazole film (brown, transparent, thickness: 40 µm).

The properties of the polyamide are shown below.
Logarithmic viscosity (ηᵢₙₕ): 0.53 dL/g (NMP solution having a 0.5 g/dL concentration, measured at 30°C)
Number average molecular weight (Mn): 50,000
Weight average molecular weight (Mw): 115,000
Molecular weight distribution (Mw/Mn): 2.3

The properties of the polybenzoxazole are shown below.
5% Weight loss temperature: 435°C (in air), 514°C (in nitrogen) (TGA)
10% Weight loss temperature: 476°C (in air), 527°C (in nitrogen) (TGA)
Carbonization yield: 64% (800°C in nitrogen) (TGA)
Glass transition temperature: 283°C (TMA), 278°C (DMA)
Thermal expansion coefficient: 69 ppm/°C (80 to 200°C)
Average refractive index (nₐᵥₑ): 1.613 (d line)
Birefringence (Δn): 0.002 (d line)
Dielectric constant (ε) calculated from refractive index: 2.60 (ε - nₐᵥₑ²)
Dielectric constant (Dₖ): 2.50 (10 GHz, TE mode), 2.51 (10 GHz, TM mode), 2.51 (20 GHz, TE mode)
Dielectric tangent (D_{f}): 0.0036 (10 GHz, TE mode), 0.0042 (10 GHz, TM mode), 0.0042 (20 GHz, TE mode)

## Claims

1. A fluorine-containing polyamide compound comprising a repeating unit represented by Formula (1): 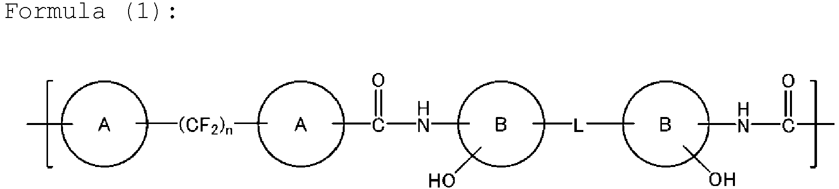 in Formula (1),
n represents an integer of 1 to 8,
L represents a linking group, and
each ring A and each ring B independently represents a hydrocarbon ring.

2. The fluorine-containing polyamide compound according to claim 1, wherein the ring A is a cyclohexane ring, a benzene ring, a naphthalene ring, a biphenyl ring, an anthracene ring, or a terphenyl ring.

3. The fluorine-containing polyamide compound according to claim 1 or 2, wherein the ring B is a cyclohexane ring, a benzene ring, a naphthalene ring, a biphenyl ring, an anthracene ring, or a terphenyl ring.

4. The fluorine-containing polyamide compound according to any of claims 1 to 3, wherein the linking group is single bond, -SO₂-, -O-, -CO-, a divalent non-fluorinated organic group, or a divalent fluorinated organic group.

5. The fluorine-containing polyamide compound according to any of claims 1 to 4, wherein the repeating unit represented by Formula (1) is a repeating unit represented by Formula (1-1), 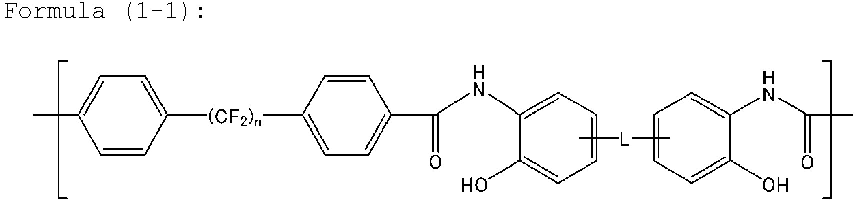 in Formula (1-1), n and L are as described above.

6. The fluorine-containing polyamide compound according to any of claims 1 to 5, wherein an average degree of polymerization of the repeating unit represented by Formula (1) is 2 to 100.

7. A fluorine-containing polybenzoxazole comprising a repeating unit represented by Formula (2): 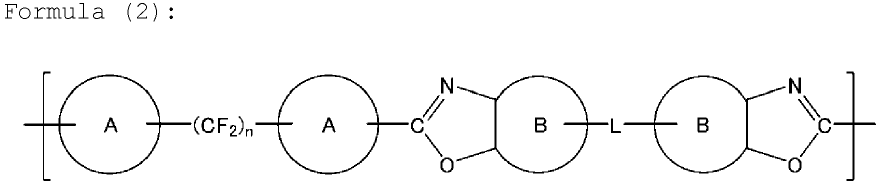 in Formula (2),
n represents an integer of 1 to 8,
L represents a linking group, and
each ring A and each ring B independently represents a hydrocarbon ring.

8. The fluorine-containing polybenzoxazole according to claim 7, wherein the ring A is a cyclohexane ring, a benzene ring, a naphthalene ring, a biphenyl ring, an anthracene ring, or a terphenyl ring.

9. The fluorine-containing polybenzoxazole according to claim 7 or 8, wherein the ring B is a cyclohexane ring, a benzene ring, a naphthalene ring, a biphenyl ring, an anthracene ring, or a terphenyl ring.

10. The fluorine-containing polybenzoxazole according to any of claims 7 to 9, wherein the linking group is single bond, -SO₂-, -O-, -CO-, a divalent non-fluorinated organic group, or a divalent fluorinated organic group.

11. The fluorine-containing polybenzoxazole according to any of claims 7 to 10, wherein the repeating unit represented by Formula (2) is a repeating unit represented by Formula (2-1), 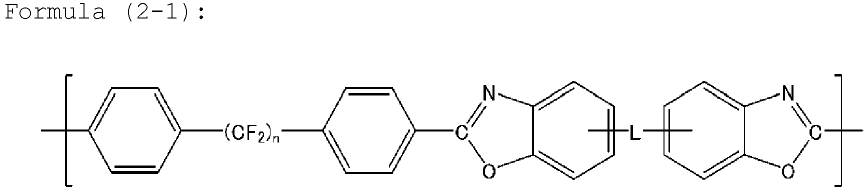 in Formula (2-1), n and L are as described above.

12. The fluorine-containing polybenzoxazole according to any of claims 7 to 11, wherein an average degree of polymerization of the repeating unit represented by Formula (2) is 2 to 100.

13. A low dielectric material comprising the fluorine-containing polyamide compound according to any of claims 1 to 6 or the fluorine-containing polybenzoxazole according to any of claims 7 to 12.

14. An insulation material of a printed circuit board, comprising the fluorine-containing polyamide compound according to any of claims 1 to 6 or the fluorine-containing polybenzoxazole according to any of claims 7 to 12.
